# EUROPEAN PATENT APPLICATION

(11) **EP 3 480 572 A1**
(43) Date of publication of application: **08.05.2019**
(21) Application number: 18169775.6
(22) Date of filing: 27.04.2018
(51) Int. Cl.: G01K 1/14

(54) **TEMPERATURE MEASURING MODULE USING A STAND-UP PASSIVE COMPONENT AND METHOD FOR MAKING THE SAME**

(30) Priority: 07.11.2017 CN 201711085120
(71) Applicant: Thinking Electronic Industrial Co., Ltd., Kaohsiung City (TW)
(72) Inventor: SUI, Chung-Hua, Kaohsiung City (TW)
(74) Representative: Pallini Gervasi, Diego

(57) **Abstract**

A temperature measuring module includes a body (1). The body (1) has a countersink hole (2) in a top portion and a connection chamber (3) in a bottom portion thereof. A metallic component holder (4) is mounted in the countersink hole (2). A return spring (5) is mounted around an upper portion of the component holder (4). A lower portion of the component holder (4) extends into the connection chamber (3) and is limited by a snap ring (6) held thereon. A passive component (15) is fixed inside the component holder (4) with pins thereof electrically connected with electrode strips (16) in the bottom portion of the body (1) to constitute a modular component. Given the foregoing structure, easy assembly and operation, close contact with objects to be measured for mitigating error in measurement, and automation of production can be achieved.

## Description

### 1. Field of the Invention

The present invention relates to stand-up passive components and, more particularly, to a temperature measuring module using a stand-up passive component and a method for making the same.

### 2. Description of the Related Art

Conventionally, passive components fail to be universally applied to customers' diversified applications for measuring objects with different structures. As far as easy manufacture of temperature measuring products using passive components and close contact between the measuring products and objects to be measured are concerned, passive components fail to be in close contact with PCBs (Printed Circuit Board) for measuring temperature and objects to be measured, rendering difficulties in measurement and in automation of production for using passive components in measuring products.

An objective of the present invention is to provide a temperature measuring module, a method for making the same and a system using the same for temperature measurement, which can meet demands for fast assembly and automatic production.

To achieve the foregoing objective, the temperature measuring module includes a body and the body has a countersink hole, a connection chamber, a metallic component holder, a return spring, a snap ring, and a stand-up passive component.

The countersink hole is formed in a top portion of the body and has stairs annularly formed around an inner wall of the countersink hole with a lowest stair smaller than a highest stair in diameter.

The connection chamber is formed on and recessed upwards from a bottom portion of the body to communicate with the countersink hole.

The metallic component holder is mounted through the countersink hole with a bottom portion penetrating into the connection chamber.

The return spring is mounted around a periphery of the metallic component holder and is located at a top portion of the countersink hole.

The snap ring is mounted on the bottom portion of the metallic component holder and is limited by a top inner wall of the connection chamber.

The stand-up passive component is mounted inside the metallic component holder with multiple pins thereof respectively electrically connected with multiple electrode strips securely mounted in the bottom portion of the body.

To achieve the foregoing objective, the method for making the temperature measuring module includes steps of:
mounting the stand-up passive component in the component slot of the metallic component holder by dispensing adhesive to attach the passive component on the inner wall of the metallic component holder;
mounting the return spring around the periphery of the metallic component holder and mounting the metallic component holder along with the return spring into the countersink hole of the body;
mounting the snap ring in the ring groove of the metallic component holder with the snap ring limited by the top inner wall of the connection chamber and the return spring lifting up the metallic component holder when the return spring is released from a compressed state, such that the metallic component holder is movably retained in the countersink hole of the upper insulating casing; and
electrically connecting the multiple pins of the passive component to the respective electrode strips that are securely mounted in a bottom portion of the body through the respective pin slots; and
enclosing the body by covering the lower insulating casing on the upper insulating casing.

To achieve the foregoing objective, the battery temperature measuring system includes a battery pack and the temperature measuring module.

The multiple electrode strips of the temperature measuring module are soldered on a circuit board for temperature measurement, and the metallic component holder of the temperature measuring module is in direct contact with the battery pack to measure temperature of the battery pack.

According to the foregoing description, the module, the method and the system for battery temperature measurement have the following technical effects.
1) By attaching a stand-up passive component to an inner wall of the metallic component holder, the metallic component holder can be detachably mounted inside the body, such that the passive component can become a modular component, which facilitates progressive assembly and thus meets enterprise demands for automation of production.
2) Given the design of the metallic component holder, the snap ring positions the metallic component holder and the return spring lifts up the metallic component holder, such that the metallic component holder can be detachably mounted in the body in a way without interfering with each other so as to speed up assembly. The return spring and the testing head also ensure that the metallic component holder is in close contact with an object to be measured (battery pack), thereby eliminating error in measuring. Accordingly, the temperature measuring module may be adapted to fit in customers' products, and not only can fast assembly of products tailored to customers' requirements be met, but also reliability of products after assembly can be secured.
3) The entire module is structurally simple. All it takes for assembly is to bond the stand-up passive component, clip the metallic component holder with the snap ring, solder pins of the passive component on the electrode strips, and cover the upper insulating casing with the lower insulating casing in completion of the assembly. Because of only a few processes involved, requirements for assembly of the temperature measuring module are low, and in turn the overall assembly efficiency can be enhanced. Besides, as all parts and elements employed are widely used and are made by inexpensive materials, cost reduction can be achieved. Under the circumstance of higher assembly efficiency, it is beneficial to gain profit from production.
4) By virtue of the inverted T-shaped upper insulating casing with a smaller top portion, conflict between the upper insulating casing and objects in the nearby of a measured point can thus be avoided. Meanwhile, the dome-like measuring head allows certain degree of inclination. The larger bottom portion of the upper insulating casing is desirable to the size of a PCB solder pad. The through holes on the left and right of the bottom portion are provided to facilitate fast soldering applied to the passive component and the electrode strips. A soldering iron can be used to first hold down a pin of the passive component on an electrode strip after passing through one of the through holes and then solder the pin and the electrode strip together by applying low-voltage and high-current power to the soldering iron.

Other objectives, advantages and novel features of the invention will become more apparent from the following detailed description when taken in conjunction with the accompanying drawings.

### IN THE DRAWINGS

Fig. 1 is a perspective view of a temperature measuring module in accordance with the present invention.
Fig. 2 is a perspective view of an upper insulating casing of the temperature measuring module in Fig. 1;
Fig. 3 is another perspective view of the upper insulating casing in Fig. 2;
Fig. 4 is a perspective view showing a stand-up passive component mounted inside a metallic component holder and connected with electrode strips of the temperature measuring module in Fig. 1;
Fig. 5 is a perspective view of a lower insulating casing in accordance with the present invention; and
Fig. 6 is a cross-sectional view of a temperature measuring module in Fig. 1.

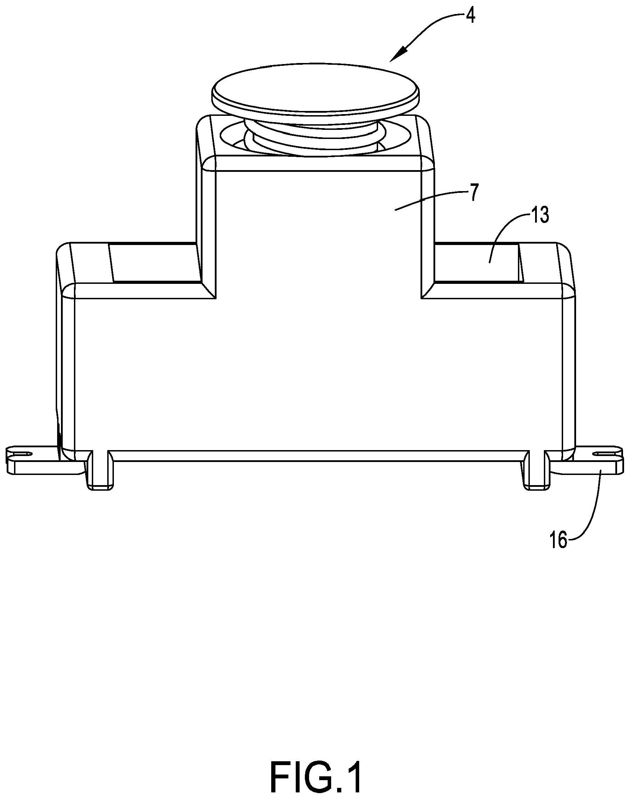

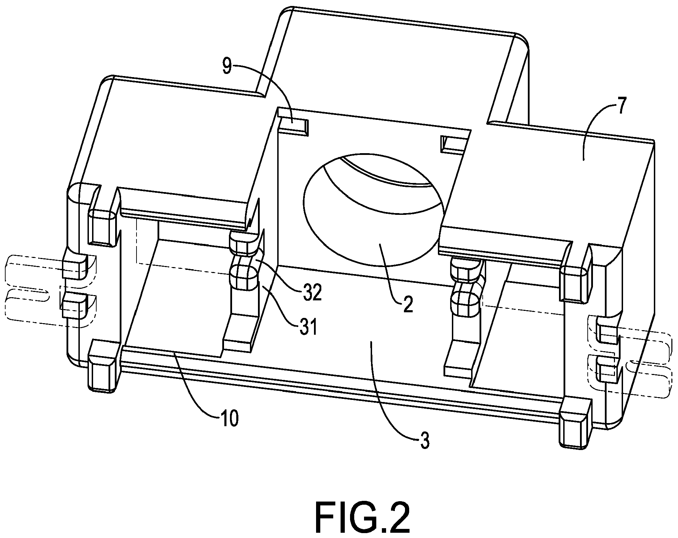

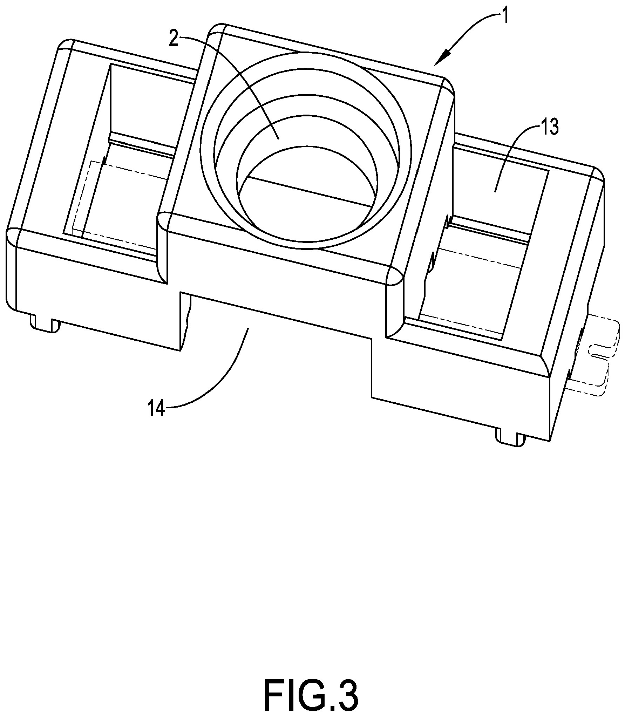

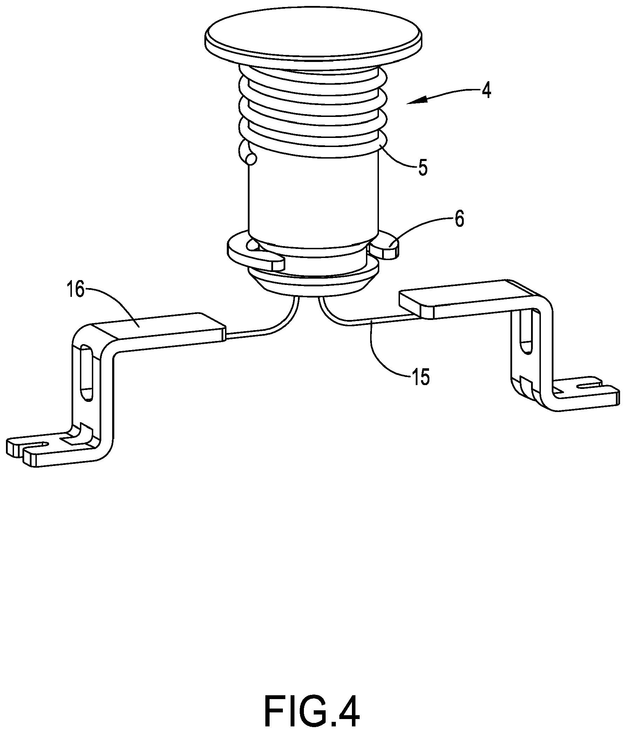

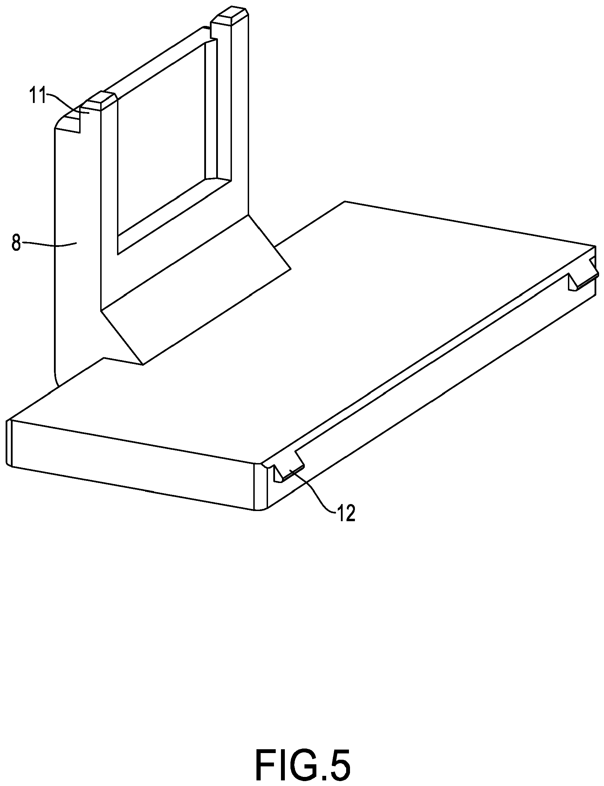

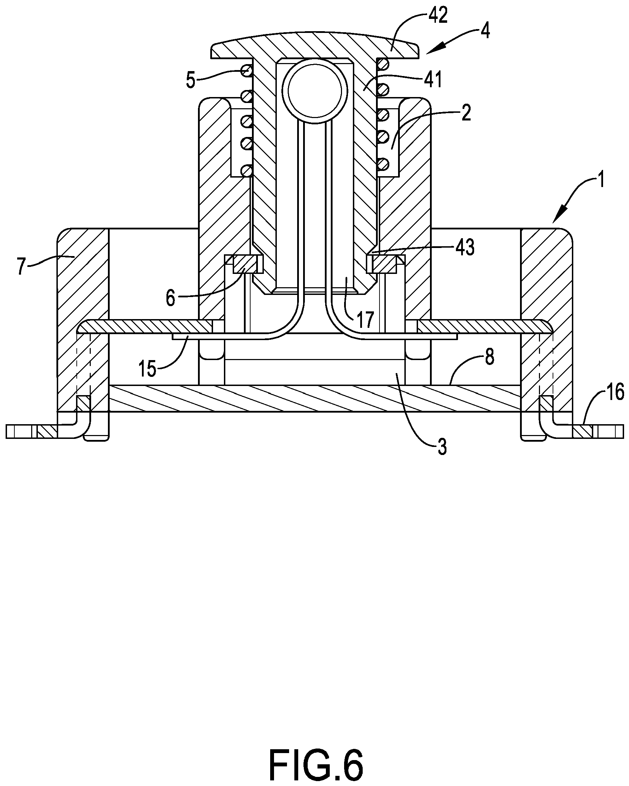

With reference to Figs. 1 to 6, a temperature measuring module in accordance with the present invention includes a body 1. The body 1 includes an upper insulating casing 7 and a lower insulating casing 8, which are made of a plastic material. The upper insulating casing 7 is inverted T-shaped and has a countersink hole 2, a connection chamber 3, a metallic component holder 4, a return spring 5 and a snap ring 6. The countersink hole 2 is formed through a top portion of the upper insulating casing 7 and has stairs annularly formed around an inner wall of the countersink hole 2 with a lowest stair smaller than a highest stair in diameter. The connection chamber 3 is formed on and recessed upwards from a bottom of the upper insulating casing 7 to communicate with the countersink hole 2. The metallic component holder 4 is mounted through the countersink hole 2 and is made of a metal material, such as aluminum, copper, stainless steel, and the like. The metallic component holder 4 takes the form of a headed pin and has a shank 41, a testing head 42 and a ring groove 43. The testing head 42 is dome-like, is formed on a top end of the metallic component holder 4, and is larger than the highest stair of the countersink hole 2 in diameter. The ring groove 43 is annularly formed in a bottom portion of a periphery of the shank 41. The return spring 5 is mounted around the periphery of the shank 41 and is located between the testing head 41 and the lowest stair of the countersink hole 2. The snap ring 6 is mounted in the ring groove 43 of the metallic component holder 4 and is limited by a top inner wall of the connection chamber 3. While the testing head 42 is pressed down until the testing head 42 is limited by the top end of the metallic component holder 4, the return spring 5 is compressed. After the testing head 42 is released, the return spring 5 returns to its uncompressed state by the stored elastic energy and the metallic component holder 4 is lifted up until the snap ring 6 is limited by the top inner wall of the connection chamber 3. Thus, the metallic component holder 4 is movably retained in the countersink hole 2 of the upper insulating casing 7 and is detachably mounted in the upper insulating casing 7. The metallic component holder 4 has a component slot 17 formed in a bottom end thereof and matching a stand-up passive component 15, such as capacitor, inductor, resistor, thermistor, varistor or the like, in size for the passive component 15 to be mounted in the component slot 17 by dispensing adhesive to attach the passive component 15 to an inner wall of the component slot 17. Pins of the passive component 15 that extend beyond the component slot 17 can be electrically connected with electrode strips 16 that are securely mounted in the body 1 and penetrate through a bottom portion of the upper insulating casing 7.

The upper insulating casing 7 further includes two partition walls 31, two engagement slots 9 and multiple wedge-receiving grooves 10. The two partition walls 31 are formed inside the connection chamber 3 to divide the connection chamber 3 into a left room, a middle room and a right room. The middle room is formed by the two partition walls 31 and a front wall, has a rear opening 14, and is directly located below the countersink hole 2 to communicate with the countersink hole 2. Each of the left room and the right room have a through hole 13 formed therethrough in an up-down direction and the two through holes 13 are symmetric to each other. Each partition wall 31 has a pin slot 32 formed through the partition wall 31 for a corresponding pin of the passive component 15 to pass through, such that the corresponding pin can be electrically connected to a bottom surface of a corresponding electrode strip 16 through a corresponding pin slot 32 by soldering or by using an electrically conductive adhesive. The two engagement slots 9 are symmetrically formed in a top inner wall of the middle room. The multiple wedge-receiving grooves 10 are respectively formed on bottom edges of front walls and rear walls of the left room and the right room.

The lower insulating casing 8 includes a flat portion and a raised portion. The flat portion covers an open bottom side of the connection chamber 3 and has multiple wedges 12. The raised portion is formed on and protrudes upwards from a perimeter of the flat portion, covers the rear opening of the middle room of the upper insulating casing 7, and has two engagement blocks 11. The two engagement blocks 11 are formed on a top of the raised portion of the lower insulating casing 8 to correspond to and engage the respective engagement slots 9. The multiple wedges 12 are formed on the perimeter of the flat portion to correspond to and engage the respective wedge-receiving grooves 10 of the upper insulating casing 7.

The foregoing temperature measuring module can be applied for temperature measurement of a battery pack. The electrode strips 16 of the temperature measuring module are soldered on a circuit board for temperature measurement, such that the metallic component holder 4 of the temperature measuring module can be in direct contact with the battery pack for temperature measurement.

A method for making the temperature measuring module in accordance with the present invention includes the following steps.
1) Mount the stand-up passive component 15 in the component slot 17 of the metallic component holder 4 by dispensing adhesive to attach the passive component 15 on the inner wall of the metallic component holder 4.
2) Mount the return spring 5 around the periphery of the metallic component holder 4 and mount the metallic component holder 4 along with the return spring 5 into the countersink hole 2 of the body 1.
3) Mount the snap ring 6 in the ring groove 43 of the metallic component holder 4 with the snap ring 6 limited by a top inner wall of the connection chamber 3 and the return spring 5 lifting up the metallic component holder 4 when the return spring 5 is released from a compressed state, such that the metallic component holder 4 can be movably retained in the countersink hole 2 of the upper insulating casing 7.
4) Solder pins of the passive component 15 on corresponding electrode strips 16 that are securely mounted inside the body 1 through the respective pin slots 32.
5) Enclose the body 1 by covering the lower insulating casing 8 on the upper insulating casing 7 to convert the stand-up passive component 15 into a modular component.

Even though numerous characteristics and advantages of the present invention have been set forth in the foregoing description, together with details of the structure and function of the invention, the disclosure is illustrative only. Changes may be made in detail, especially in matters of shape, size, and arrangement of parts within the principles of the invention to the full extent indicated by the broad general meaning of the terms in which the appended claims are expressed.

## Claims

1. A temperature measuring module comprising a body (1);
**characterized in that** the body (1) has:
a countersink hole (2) formed in a top portion of the body (1) and having stairs annularly formed around an inner wall of the countersink hole (2) with a lowest stair smaller than a highest stair in diameter;
a connection chamber (3) formed on and recessed upwards from a bottom portion of the body (1) to communicate with the countersink hole (2);
a metallic component holder (4) mounted through the countersink hole (2) with a bottom portion penetrating into the connection chamber (3);
a return spring (5) mounted around a periphery of the metallic component holder (4) and located at a top portion of the countersink hole (2);
a snap ring (6) mounted on the bottom portion of the metallic component holder (4) and limited by a top inner wall of the connection chamber (3); and
a stand-up passive component (15) mounted inside the metallic component holder (4) with multiple pins thereof respectively electrically connected with multiple electrode strips securely mounted in the bottom portion of the body (1).

2. The temperature measuring module as claimed in claim 1, wherein the body (1) includes:
an upper insulating casing (7) having:
two partition walls (31) formed inside the connection chamber (3) to divide the connection chamber (3) into a left room, a middle room and a right room, each partition wall (31) having a pin slot (32) formed through the partition wall (31) for a corresponding pin of the passive component (15) to pass through, wherein the middle room is directly located below the countersink hole (2) to communicate with the countersink hole (2);
two engagement slots (9) symmetrically formed in a top inner wall of the middle room; and
multiple wedge-receiving grooves (10) respectively formed on bottom edges of front walls and rear walls of the left room and the right room; and
a lower insulating casing (8) having:
two engagement blocks (11) formed thereon and corresponding to and engaging the respective engagement slots (9) of the upper insulating casing (7); and
multiple wedges (12) formed thereon and corresponding to and engaging the respective wedge-receiving grooves (10) of the upper insulating casing (7).

3. The temperature measuring module as claimed in claim 2, wherein the upper insulating casing (7) is inverted T-shaped and has two through holes (13) symmetrically formed through a left portion and a right portion of the upper insulating casing (7) in an up-down direction and a rear opening (14).

4. The temperature measuring module as claimed in claim 1, wherein the metallic component holder (4) takes the form of a headed pin and has:
a shank (41);
a testing head (42) formed on a top end of the metallic component holder (4) and being larger than the highest stair of the countersink hole (2) in diameter; and
a ring groove (43) annularly formed in a bottom portion of a periphery of the shank (41);
wherein the return spring (5) is mounted around the periphery of the shank (41) and is located between the testing head (42) and the lowest stair of the countersink hole (2), and the snap ring (6) is mounted in the ring groove (43) of the metallic component holder (4) and is limited by the top inner wall of the connection chamber (3).

5. The temperature measuring module as claimed in claim 1, wherein the metallic component holder (4) has a component slot (17) formed in a bottom end thereof and matching the stand-up passive component (15) in size for the passive component (15) to be mounted in the component slot (17) by dispensing adhesive to attach the passive component (15) to an inner wall of the component slot (17).

6. A method for making the temperature measuring module as claimed in claims 2 to 5, **characterized in that** the method comprises steps of:
mounting the stand-up passive component (15) in the component slot (17) of the metallic component holder (4) by dispensing adhesive to attach the passive component (15) on the inner wall of the metallic component holder (4);
mounting the return spring (5) around the periphery of the metallic component holder (4) and mounting the metallic component holder (4) along with the return spring (5) into the countersink hole (2) of the body (1);
mounting the snap ring (6) in the ring groove (43) of the metallic component holder (4) with the snap ring (6) limited by the top inner wall of the connection chamber (3) and the return spring (5) lifting up the metallic component holder (4) when the return spring (5) is released from a compressed state, such that the metallic component holder (4) is movably retained in the countersink hole (2) of the upper insulating casing (7); and
electrically connecting the multiple pins of the passive component (15) to the respective electrode strips (16) through the respective pin slots (32); and
enclosing the body (1) by covering the lower insulating casing (8) on the upper insulating casing (7).

7. A battery temperature measuring system, **characterized in that** the system comprises:
a battery pack; and
the temperature measuring modules as claimed in claims 1 to 5, wherein the multiple electrode strips (16) of the temperature measuring module are soldered on a circuit board for temperature measurement, and the metallic component holder (4) of the temperature measuring module is in direct contact with the battery pack to measure temperature of the battery pack.

## Amended claims

### Amended claims in accordance with Rule 137(2) EPC.

1. A temperature measuring module comprising a body (1);
**characterized in that** the body (1) has:
multiple electrode strips (16) securely mounted in a bottom portion of the body (1);
a countersink hole (2) formed in a top portion of the body (1) and having stairs annularly formed around an inner wall of the countersink hole (2) with a lowest stair smaller than a highest stair in diameter;
a connection chamber (3) formed on and recessed upwards from a bottom portion of the body (1) to communicate with the countersink hole (2);
a metallic component holder (4) mounted through the countersink hole (2) with a bottom portion penetrating into the connection chamber (3);
a return spring (5) mounted around a periphery of the metallic component holder (4) and located at a top portion of the countersink hole (2);
a snap ring (6) mounted on the bottom portion of the metallic component holder (4) and limited by a top inner wall of the connection chamber (3); and
a stand-up passive component (15) mounted inside the metallic component holder (4) with multiple pins thereof respectively electrically connected with the multiple electrode strips (16).

2. The temperature measuring module as claimed in claim 1, wherein the body (1) includes:
an upper insulating casing (7) having:
two partition walls (31) formed inside the connection chamber (3) to divide the connection chamber (3) into a left room, a middle room and a right room, each partition wall (31) having a pin slot (32) formed through the partition wall (31) for a corresponding pin of the passive component (15) to pass through, wherein the middle room is directly located below the countersink hole (2) to communicate with the countersink hole (2);
two engagement slots (9) symmetrically formed in a top inner wall of the middle room; and
multiple wedge-receiving grooves (10) respectively formed on bottom edges of front walls and rear walls of the left room and the right room; and
a lower insulating casing (8) having:
two engagement blocks (11) formed thereon and corresponding to and engaging the respective engagement slots (9) of the upper insulating casing (7); and
multiple wedges (12) formed thereon and corresponding to and engaging the respective wedge-receiving grooves (10) of the upper insulating casing (7).

3. The temperature measuring module as claimed in claim 2, wherein the upper insulating casing (7) is inverted T-shaped and has two through holes (13) symmetrically formed through a left portion and a right portion of the upper insulating casing (7) in an up-down direction and a rear opening (14).

4. The temperature measuring module as claimed in claim 1, wherein the metallic component holder (4) takes the form of a headed pin and has:
a shank (41);
a testing head (42) formed on a top end of the metallic component holder (4) and being larger than the highest stair of the countersink hole (2) in diameter; and
a ring groove (43) annularly formed in a bottom portion of a periphery of the shank (41);
wherein the return spring (5) is mounted around the periphery of the shank (41) and is located between the testing head (42) and the lowest stair of the countersink hole (2), and the snap ring (6) is mounted in the ring groove (43) of the metallic component holder (4) and is limited by the top inner wall of the connection chamber (3).

5. The temperature measuring module as claimed in claim 1, wherein the metallic component holder (4) has a component slot (17) formed in a bottom end thereof and matching the stand-up passive component (15) in size for the passive component (15) to be mounted in the component slot (17) by dispensing adhesive to attach the passive component (15) to an inner wall of the component slot (17).

6. A method for making the temperature measuring module as claimed in claims 2 to 5, **characterized in that** the method comprises steps of:
mounting the stand-up passive component (15) in the component slot (17) of the metallic component holder (4) by dispensing adhesive to attach the passive component (15) on the inner wall of the metallic component holder (4);
mounting the return spring (5) around the periphery of the metallic component holder (4) and mounting the metallic component holder (4) along with the return spring (5) into the countersink hole (2) of the body (1);
mounting the snap ring (6) in the ring groove (43) of the metallic component holder (4) with the snap ring (6) limited by the top inner wall of the connection chamber (3) and the return spring (5) lifting up the metallic component holder (4) when the return spring (5) is released from a compressed state, such that the metallic component holder (4) is movably retained in the countersink hole (2) of the upper insulating casing (7); and
electrically connecting the multiple pins of the passive component (15) to the respective electrode strips (16) through the respective pin slots (32); and
enclosing the body (1) by covering the lower insulating casing (8) on the upper insulating casing (7).
